# NEUE EUROPÄISCHE PATENTSCHRIFT

(11) **EP 2 275 471 B2**
(45) Veröffentlichungstag und Bekanntmachung des Hinweises auf die Entscheidung über den Einspruch: **09.12.2015**
(45) Hinweis auf die Patenterteilung: 31.08.2011
(21) Anmeldenummer: 09163070.7
(22) Anmeldetag: 18.06.2009
(51) Int. Cl.: C08G 69/02, C09D 177/02, C09D 177/06, H01L 31/048

(54) **Photovoltaikmodul-Monorückfolie, Verfahren zu deren Herstellung sowie deren Verwendung bei der Produktion photovoltaischer Module**
Photovoltaic module mono-backsheet, method for manufacturing same and use of same in the production of photovoltaic modules
Monofeuille dorsale de module photovoltaïque, son procédé de fabrication et son utilisation dans la production de modules photovoltaïques

(43) Veröffentlichungstag der Anmeldung: 19.01.2011
(73) Patentinhaber: EMS-PATENT AG, 7013 Domat/Ems (CH)
(72) Erfinder: Sturzel, André, 7206, Igis (CH); Stöppelmann, Georg Dr., 7402, Bonaduz (CH); Etzel, Dietmar, 8867, Niederurnen (CH); Hoffmann, Botho Dr., 7013, Domat/Ems (CH)
(74) Vertreter: OK pat AG

(56) Entgegenhaltungen:
- EP-A1- 1 731 569
- EP-A1- 1 731 569
- EP-A1- 1 942 147
- EP-A1- 2 070 973
- EP-A1- 2 422 976
- EP-A1- 2 599 629
- EP-A2- 2 043 162
- WO-A1-94/22172
- WO-A2-2008/138021
- WO-A2-2008/138021
- WO-A2-2009/156323
- US-A- 5 866 658
- US-A1- 2003 235 666
- US-A1- 2004 144 415
- ISO 1874-1:1992(E)- Plastics-Polyamide (PA) moulding and extrusion materials

## Beschreibung

Die Erfindung betrifft photovoltaische Module, d.h. Solarzellenmodule zur photoelektrischen Stromerzeugung. In einem solchen Photovoltaikmodul ist eine Anzahl einzelner Solarzellen auf einer Fläche zusammengefasst und zusammengeschaltet. Möglich sind auch Module mit nur einer Solarzelle. Die Solarzellen sind dünne Scheiben aus Halbleitermaterial, die beim Belichten eine elektrische Spannung abgeben und so das eingestrahlte Sonnenlicht direkt in elektrische Energie umwandeln. Als Halbleitermaterial wird zu diesem Zweck hauptsächlich Silizium verwendet. In grösseren photovoltaischen Solaranlagen werden viele Module in Reihe geschaltet, was eine hohe elektrische Anlagenspannung und -Leistung ergibt.

Ein photovoltaisches Modul oder Photovoltaikmodul ist üblicherweise tafelförmig als Laminat aufgebaut: Zuoberst ist eine transparente Scheibe z.B. aus Spezialglas angeordnet. Darunter schliesst eine haftvermittelnde Folie bevorzugt aus Ethylenvinylacetat (EVA) an, welche die transparente Scheibe mit den eigentlichen Solarzellen (mehrere Siliziumscheiben oder auch nur eine einzelne Siliziumscheibe) verbinden soll. Eine weitere Haftvermittlerfolie (EVA) verbindet die Unterseiten der Solarzellen mit einer etwas dickeren Rückfolie, welche die rückseitige Schutzschicht des Moduls darstellt. Der Verbund dieser Schichten wird jeweils in einer Vakuumpresse thermisch verfestigt (so dass die Schichten beim Heissverpressen über das EVA miteinander verkleben). Dabei werden die Schichtmaterialien zunächst in der umgekehrten Reihenfolge in die Presse hineingelegt, damit die Glasscheibe beim Laminieren als starre Unterlage für die anderen Schichten dienen kann. Auf diese Weise werden die Solarzellen im elastischen und transparenten EVA-Schmelzkleber eingebettet, und zwischen dem Glas und der Rückfolie eingekapselt. Die Rückfolie eines solchen photovoltaischen Moduls ist der Hauptgegenstand der vorliegenden Erfindung.

Eine gute Beschreibung dieses technologischen Hintergrunds liefert die internationale Patentanmeldung WO 94/22172. Als bevorzugte Rückfolie wird dort Tedlar^{®} (trademark of E. I. du Pont de Nemours and Company), eine Folie aus Polyvinylfluorid (PVF), genannt. Die Tedlar^{®}-Rückfolie kommt in der Praxis meist in Form einer dreischichtigen Folie (PVF/PET/PVF) zum Einsatz. WO 94/22172 offenbart als mögliche Materialien für die rückseitige Modulschicht noch weitere thermoplastische Kunststoffe wie Polyolefine, Polyester, diverse Polyamide (NyIons), Polyetherketone, Fluorpolymere, etc.

Die Verwendung von Polyamid als Einkapselungsmaterial für photovoltaische Module steht im Zentrum der internationalen Patentanmeldung WO 2008/138021 A2. Dieses Dokument weist einleitend auf den Stand der Technik mit den Mehrschichtfolienverbunden aus Fluorpolymer und Polyester (d.h. PVF und PET) als (rückseitiges) Einkapselungsmaterial hin. Weil die Haftung dieses Einkapselungsmaterials zum Einbettungsmaterial, dem Ethylenvinylacetat (EVA) gering sei, wird in der WO 2008/138021 A2 Polyamid (PA) als Einkapselungsmaterial, d.h. als Material für die Verwendung in Rückfolien von Photovoltaikmodulen, vorgeschlagen. Verschiedene Polyamidtypen werden explizit genannt: PA 6, PA 66, PA 7, PA 9, PA 10, PA 11, PA 12, PA 69, PA 610, PA 612, PA 6-3-T, PA 6I und Polyphthalamid (PPA). Im Dokument WO 2008/138021 A2 wird die Eignung der aufgezählten PA-Typen aber weder für die Verwendung in einem Folienverbund noch als Monofolie experimentell belegt.

Als mögliches Rückfolienmaterial wird Polyamid 11 auch im Fachartikel "Bio Based Backsheet" von S.B. Levy erwähnt, welcher in Proc. of SPIE (2008) Vol. 7048 (Reliability of Photovoltaic Cells, Modules, Components, and Systems), 70480C/1-10 erschienen ist. In diesem Artikel wird Nylon 11 (oder PA 11) als ein sinnvolles Material für Rückfolien betrachtet, weil es auf einer nachwachsenden Rohstoffquelle basiert (Rizinusöl). Weiterhin wird offenbart, dass PA 11 trotzdem beständig ist (d.h. nicht biologisch abbaut), und somit von Interesse für einen Einsatz bei der umweltfreundlichen Sonnenenergiegewinnung ist. Zudem wird offenbart, dass in der Praxis das Nylon 11 nicht allein, sondern immer im Verbund mit einem anderen Folienmaterial (z.B. Cellulose) als Rückfolie eingesetzt würde.

Zu demselben Schluss kommt auch US 2009/0101204 A1, als deren erster Erfinder ebenfalls S.B. Levy genannt ist. Hier wird das Polyamid 11 (nylon-11 layer 510) im Verbund mit einem speziellen, elektrisch isolierenden Papier (505) als Photovoltaik-Rückfolie (500) verwendet (vgl. Fig. 5 und entsprechende Erläuterungen). Das Polyamid 11 wird dabei durch Extrusionsbeschichtung auf das Papier aufgetragen.

WO 2008/138022 A1 beschreibt Polyamid 12 ebenfalls als Schichtmaterial für Schutzfolien von photovoltaischen Modulen und weist zudem darauf hin, dass diese Folienverbunde hauptsächlich aus einer Trägermaterialschicht ausgewählt aus Polyester (PET oder PEN) oder dem Fluorpolymer ETFE bestehen.

Im Unterschied zum Stand der Technik, welcher in der Regel mehrschichtige Rückfolien vorsieht, liegt der vorliegenden Erfindung die Aufgabe zugrunde, geeignete alternative Polyamide zu finden, auf deren Basis alternative einschichtige Rückfolien (Monofolien) für photovoltaische Module hergestellt werden können.

Diese Aufgabe wird mit einer Rückfolie basierend auf Polyamid mit den Merkmalen des Patentanspruchs 1 gelöst. In den Unteransprüchen sind bevorzugte Ausführungsformen angegeben. Zudem ist ein Verfahren zur Herstellung solcher Rückfolien beansprucht, sowie deren Verwendung zur Herstellung photovoltaischer Module.

Gemäss der Erfindung wird die Aufgabe gelöst mit einer aus einer auf mindestens einem Polyamid basierenden Formmasse hergestellten Photovoltaikmodul-Monorückfolie, wobei die Polyamid-Formmasse mindestens ein Weisspigment als Zusatzstoff enthält, wobei das mindestens eine Polyamid aufgebaut ist aus linearen und/oder verzweigten aliphatischen und/oder cycloaliphatischen Monomeren, die im Durchschnitt mindestens 8 und maximal 17 C-Atome aufweisen und die ausgewählt sind aus der Gruppe bestehend aus Diaminen, Dicarbonsäuren, Lactamen und Aminocarbonsäuren sowie Mischungen derselben, wobei Polyamid 610 und Polyamid 612 ausgeschlossen sind, und wobei die auf Lactamen und Aminocarbonsäuren basierenden Polyamide vernetzt sind, wobei das Polyamid ausgewählt ist aus der Gruppe Polyamid 4**X**, Polyamid 4**X** vernetzt, Polyamid 9 vernetzt, Polyamid 99, Polyamid 99 vernetzt, Polyamid 910, Polyamid 910 vernetze, Polyamid 1010, Polyamid 1010 vernetzt, Polyamid 11 vernetzt, Polyamid 12 vernetzt, Polyamid 1010/10CHDA, Polyamid 1010/10CHDA vernetzt, Polyamid 610/10CHDA, Polyamid 610/10CHDA vernetzt, Polyamid 612/10CHDA, Polyamid 612/10CHDA vernetzt, Polyamid 910/10CHDA, Polyamid 910/10CHDA vernetzt, Polyamid 912/10CHDA, Polyamid 912/10CHDA vernetzt, Polyamid 1012/10CHDA, Polyamid 1012/10CHDA vernetzt, Polyamid 610/12CHDA, Polyamid 610/12CHDA vernetzt, Polyamid 612/12CHDA, Polyamid 612/12CHDA vernetzt, Polyamid 910/12CHDA, Polyamid 910/12CHDA vernetzt, Polyamid 912/12CHDA, Polyamid 912/12CHDA vernetzt, Polyamid 1012/12CHDA, Polyamid 1012/12CHDA vernetzt Polyamid 1212/12CHDA, Polyamid 1212/12CHDA vernetzt Polyamid 1212/lOCHDA Polyamid 1212/10CHDA vernetzt, Polyamid 1012, Polyamid 1012 vernetzt Polyamid 1014, Polyamid 1014 vernetzt, Polyamid 1212 vernetzt, Polyamid 1210, Polyamid 1210 vernetzt, Polyamid MACM**Y** vernetzt, Polyamid PACM**Y** vernetzt, Polyamid MACM**Y**/PACM**Y** vernetzt, und Mischungen davon, wobei:
**X** eine lineare aliphatische Dicarbonsäure mit 12 bis 18 C-Atomen bezeichnet, und
**Y** eine lineare aliphatischen Dicarbonsäure mit 9 bis 18 C-Atomen bezeichnet.

Dass die für das Polyamid ausgewählten Monomere *im Durchschnitt* mindestens 8 und maximal 17 C-Atome aufweisen, erweitert die Auswahlpalette für einzelne Monomere nach unten hin (verglichen mit der engeren Bedingung, dass jedes im Polyamid enthaltene Monomer mindestens 8 C-Atome aufweisen müsste) und gründet auf der Überlegung, dass gegebenenfalls kurze Monomere (z.B. kurzkettige Diamine) mit langen Monomeren der anderen Sorte (z.B. langkettigen Dicarbonsäuren) im selben Polyamid so kompensiert oder überkompensiert werden können, dass *der Durchschnitt* mindestens 8 C-Atome (und maximal 17 C-Atome) ergibt. Ein Beispiel für ein Polyamid, bei dem zwar die Durchschnittsanforderung erfüllt ist, aber nicht jedes Monomer mindestens 8 C-Atome aufweist, ist PA 412, das aus dem 4er-Diamin Butandiamin und der 12er-Dicarbonsäure Dodecandisäure aufgebaut ist.

Die Monomere sind ausgewählt aus der Gruppe, die aus Diaminen, Dicarbonsäuren, Lactamen und Aminocarbonsäuren sowie Mischungen derselben besteht. Als Bedingungen (zur Abgrenzung vom Stand der Technik) gelten zudem: Ausgenommen von der vorliegenden Erfindung sind die Polyamide PA 610 und PA 612, und andererseits sind die auf Lactamen und Aminocarbonsäuren basierenden Polyamide vernetzt.

Die auf Diaminen und Dicarbonsäuren basierenden Polyamide aus dem genannten Bereich stellen sowohl in unvernetzter als auch in vernetzter Form bevorzugte Varianten dar.

Das Polyamid kann neben aliphatischen Monomeren wie gesagt auch cycloaliphatische Monomere enthalten, von denen folgende bevorzugt sind: CHDA (Abkürzung für die cycloaliphatische Monomerverbindung Cyclohexandicarbonsäure, wobei das 1,4-CHDA gemeint ist), BAC (Abkürzung für Bisaminocyclohexan), PACM (= 4,4'-Diaminodicyclohexyl-methan), MACM (= 3,3'-Dimethyl-4,4'-diaminodicyclohexylmethan), und Mischungen der cycloaliphatischen Diamine.

Das Polyamid ist ausgewählt aus der Gruppe Polyamid 4X (X = lineare aliphatische Dicarbonsäure mit 12 bis 18 C-Atomen), Polyamid 4X vernetzt, Polyamid 9 vernetzt, Polyamid 99, Polyamid 99 vernetzt, Polyamid 910, Polyamid 910 vernetzt, Polyamid 1010, Polyamid 1010 vernetzt, Polyamid 11 vernetzt, Polyamid 12 vernetzt, Polyamid 1010/10CHDA, Polyamid 1010/10CHDA vernetzt, Polyamid 610/10CHDA, Polyamid 610/10CHDA vernetzt, Polyamid 612/10CHDA, Polyamid 612/10CHDA vernetzt, Polyamid 910/10CHDA, Polyamid 910/10CHDA vernetzt, Polyamid 912/10CHDA, Polyamid 912/10CHDA vernetzt, Polyamid 1012/10CHDA, Polyamid 1012/10CHDA vernetzt, Polyamid 610/12CHDA, Polyamid 610/12CHDA vernetzt, Polyamid 612/12CHDA, Polyamid 612/12CHDA vernetzt, Polyamid 910/12CHDA, Polyamid 910/12CHDA vernetzt, Polyamid 912/12CHDA, Polyamid 912/12CHDA vernetzt, Polyamid 1012/12CHDA, Polyamid 1012/12CHDA vernetzt, Polyamid 1212/12CHDA, Polyamid 1212/12CHDA vernetzt, Polyamid 1212/10CHDA, Polyamid 1212/10CHDA vernetzt, Polyamid 1012, Polyamid 1012 vernetzt, Polyamid 1014, Polyamid 1014 vernetzt, Polyamid 1212 vernetzt, Polyamid 1210, Polyamid 1210 vernetzt, Polyamid MACMY vernetzt (Y = lineare aliphatische Dicarbonsäure mit 9 bis 18 C-Atomen), Polyamid PACMY vernetzt, Polyamid MACMY/ PACMY vernetzt, und Mischungen davon.

Besonders bevorzugt ist das Polyamid ausgewählt aus der Gruppe Polyamid 1010 und Polyamid 1010 vernetzt.

Unter dem Oberbegriff Polyamid (abgekürzt PA) werden übrigens Homopolyamide, Copolyamide, sowie Mischungen (Blends) aus Homopolyamiden und/oder Copolyamiden verstanden.

Die Polyamid-Formmasse der erfindungsgemässen Rückfolie enthält mindestens ein Weisspigment und bevorzugterweise weitere einen Zusatzstoffe, ausgewählt aus UV-Stabilisatoren, UV-Absorbern, Antioxidantien, Hitzestabilisatoren, Hydrolysestabilisatoren, Vernetzungsaktivatoren, Flammschutzmitteln, Schichtsilikaten, Füllstoffen, Farbmitteln (umfassend Farbstoffe und Farbpigmente), Verstärkungsmitteln, Haftvermittlern, Schlagzähigkeitsmodifikatoren und Fluorpolymeren.

Durch die Auswahl des Polyamids aus dem beanspruchten Bereich, sowie dem optionalen Zusetzen eines oder mehrerer dieser Zusatzstoffe, erfüllt die erfindungsgemässe Polyamid-Photovoltaikmodul-Monorückfolie in einer besonders bevorzugten Ausführungsform und in einer einzigen Schicht alle wesentlichen Anforderungen an eine solche Rückfolie, wie Witterungsstabilität (UV- und Hydrolysebeständigkeit), Hitzebeständigkeit, mechanischer Schutz, elektrische Isolierung, hohe Reflektivität und gute Haftung.

Beim Weisspigment, das die gewünschte hohe Reflektivität ergibt, handelt es sich bevorzugt um Titandioxid (z.B. in der Rutil- oder Anatas-Kristallmodifikation). Titandioxid wirkt gleichzeitig auch als UV-Absorber. Andere mögliche Weisspigmente sind z.B. Zinkoxid und Zinksulfid. Die mit Weisspigmenten erzielte Reflektivität der Rückfolie beträgt bevorzugt mindestens 92 %.

Zur Herstellung der erfindungsgemässen Photovoltaikmodul-Monorückfolie wird am besten das Verfahren der Extrusion angewandt. Wenn dabei eine Vernetzung des Polyamids erzielt werden soll, so wird der Polyamid-Formmasse vor der Formgebung ein Vernetzungsaktivator zudosiert. Bevorzugte Vernetzungsaktivatoren sind z.B. TMPTMA (= Trimethylolpropantrimethacrylat) und TAIC (= Triallylisocyanurat). Die Vernetzung kann bei entsprechendem Aktivator schon bei der Compoundierung bzw. Folienextrusion in-line auf radikalische Art durchgeführt werden. Bevorzugt wird die Vernetzung aber hinterher an der extrudierten Folie durch energiereiche Bestrahlung ausgelöst. Die energiereiche Bestrahlung erfolgt vorzugsweise durch Elektronenbestrahlung.

Die so hergestellte Rückfolie der erfindungsgemässen Zusammensetzung wird zur Herstellung photovoltaischer Module verwendet.

Die Varianten mit dem vernetzten Polyamid 11 sowie dem Polyamid 910 (unvernetzt und vernetzt), dem Polyamid 1010 (unvernetzt und vernetzt), dem Polyamid 1010/10CHDA (unvernetzt und vernetzt), dem Polyamid 1012 (unvernetzt und vernetzt) und dem Polyamid 1210 (unvernetzt und vernetzt) können übrigens das ökologische Argument geltend machen, dass sie auf einer nachwachsenden Rohstoffbasis beruhen, denn Rizinusöl ist nicht nur die Ausgangsbasis zur Herstellung des PA11-Monomers, sondern auch für die Sebacinsäure (Decandisäure) und Decandiamin, welche zur Synthese von Polyamiden mit 10er-Disäure und/oder 10er-Diamin dienen. Zudem ist auch Azelainsäure (d.h. die C9-Disäure) aus Rizinusöl zugänglich, die in PA 99 bzw. PA (M und/oder P)ACM9 vorkommt.

Nachfolgend wird die Erfindung an Hand von Beispielen und Vergleichsbeispielen näher erläutert. Dabei wird ersichtlich, dass einige der in der WO 2008/138021 A2 genannten Polyamide für den Einsatz als Mono-Rückfolie nicht alle Anforderungen erfüllen. Schon ohne Vergleichsversuche kann man sagen, dass z.B. Polyamid 6 und Polyamid 66 wegen ihrer hohen Wasseraufnahme nicht in Frage kommen. Teilaromatische Polyamide wie Polyphthalamide (PPA) sind nicht geeignet, weil aromatische Monomere nicht UV-beständig sind. Normales Polyamid 11 und Polyamid 12 haben andererseits das Problem, dass ihr Schmelzpunkt nur wenig über der Laminierungstemperatur bei der Modul-Herstellung in der Vakuumpresse liegt. Durch Vernetzung lässt sich dieses Verarbeitungsproblem entschärfen, d.h. es können höhere Laminierungstemperaturen angewandt werden, ohne dass das Polyamid wegzufliessen beginnt. Zudem kann durch Vernetzung die Beständigkeit, d.h. die Lebensdauer der Rückfolie im Ausseneinsatz, erhöht werden.

In den als Beispiele und Vergleichsbeispiele bezeichneten durchgeführten Versuchen gemäss den Tabellen 1 bis 4 wurden die folgenden Materialien verwendet:

| | |
|---|---|
| PA12: | Polyamid 12 (ηᵣₑₗ = 1,85), EMS-CHEMIE AG, Schweiz |
| PA 612: | Polyamid 612 (ηᵣₑₗ = 1,80), EMS-CHEMIE AG, Schweiz |
| PA1010: | Polyamid 1010 (nᵣₑₗ = 1,92), EMS-CHEMIE AG, Schweiz (Relative Viskosität ηᵣₑₗ jeweils gemessen nach der unten angegebenen Methode) |
| Antioxidans 1: | Ethylenbis(oxyethylen)bis[3-(5-tert-butyl-4-hydroxy-m-tolyl)propionat] Antioxidans auf Basis eines sterisch gehinderten Phenols |
| Antioxidans 2: | Tetrakis(2,4-di-tert-butylphenyl)-[1,1-biphenyl]-4,4'-diylbisphosphonit Antioxidans auf Phosphonit-Basis |
| UV-Absorber: | N-(2-Ethoxyphenyl)-N'-(2-ethylphenyl)oxamid |
| UV/Hitzestabilisator: | N,N'-Bis-2,2,6,6-tetramethyl-4-piperidinyl-1,3-benzoldicarboxamid |
| TiO₂: | Titandioxid, Rutil-Typ |
| TMPTMA: | Trimethylolpropantrimethacrylat Vernetzungsaktivator |

Die Formmassen der Zusammensetzungen gemäss Tabelle 1 wurden auf einen Zweiwellenextruder der Fa. Werner u. Pfleiderer Typ ZSK 25 hergestellt. Die jeweiligen Polyamid-Granulate wurden zusammen mit den Stabilisatoren in den Einzug, und das Titandioxid mit einer Seitenförderung in die Schmelze dosiert. Der Vernetzungsaktivator wird vorzugsweise mit einer Pumpe, in eine noch kalte Zone nach dem Einzug dosiert.

Die Gehäusetemperatur wurde als aufsteigendes Profil bis 270 °C eingestellt. Bei einer Schneckendrehzahl von 200 upm (Umdrehungen pro Minute) wurden 12 kg Durchsatz pro Stunde erreicht. Die Granulierung erfolgte mittels Stranggranulierung. Nach Trocknung bei 80 °C für 24h wurden die Granulateigenschaften gemessen und Flachfolien hergestellt.

Die Flachfolien wurden auf einer Collin-Laboranlage hergestellt, Typ 3300, 3-Zonenschnecke mit 30 mm Durchmesser, L/D-Verhältnis = 25. Chill-Roll Typ 136/350. Die Zylindertemperaturen und Werkzeugtemperaturen sind in Tabelle 1 beschrieben. Die Breite der Folien betrug 300 mm und die Dicke 300 µm (= 0.3 mm). Aus diesen Folien wurden mittels Wasserstrahlschneiden Schlagzugstäbe in der Form gemäss DIN 53448 geschnitten.

Bei Varianten mit Vernetzungsaktivator erfolgte die Elektronenstrahlvernetzung an Folien, die auf ein Format DIN A4 geschnitten worden waren. Die Beschleunigungsspannung betrug 10 MeV, die Dosis 125 kGy.

Die Hitzelagerung erfolgte in Umluftöfen bei 80 °C, 100 °C und 120 °C nach ISO 2578/IEC216-1.

Bewitterungstests wurden in einem Weatherometer-Bewitterungsgerät Typ CI4000 unter folgenden Bedingungen durchgeführt: Bestrahlungsleistung 0.50 W/m², Zyklus 102/18 Minuten (trocken/beregnet). Die Schwarztafeltemperatur betrug 65 °C ± 3 °C, die Feuchte 65% ± 5%.

Als Kriterium für die Temperatur- und Bewitterungsbeständigkeit wurden Schlagzugzähigkeit (DIN 53448) und Farbdifferenz Δ_{E}D65 (DIN 6174) (d.h. die Farbverschlechterung) gemessen.

Relative Viskosität ηᵣₑₗ: gemäss EN ISO 307 (2003), gemessen an einer Lösung von 0.5 Gew.-% Polyamid in m-Kresol (d.h. 0.5 g Polyamid in 100 ml Lösung) bei einer Temperatur von 25 °C. Definitionsgemäss ist ηᵣₑₗ = η/η₀ (Viskosität der Lösung dividiert durch die Viskosität des Lösungsmittels).

MVR (Melt volume rate): Schmelzflussindex ausgedrückt in der Einheit cm³/10min und nach ISO 1133 bei 275 °C und einer Belastung von 5 kg gemessen.

Das PA 612 diente als Vergleichsbeispiel gemäss Stand der Technik (in den folgenden Tabellen als V1 bezeichnet), während die erfindungsgemässen Beispiele bezeichnet wurden mit E1 (entspricht PA 1010), E2 (PA 1010 vernetzt) und E3 (PA 12 vernetzt).

Tabelle 1 zeigt eine Zusammenstellung der durchgeführten Versuche und der jeweiligen Zusammensetzung der verwendeten Materialien und Maschinenparameter.

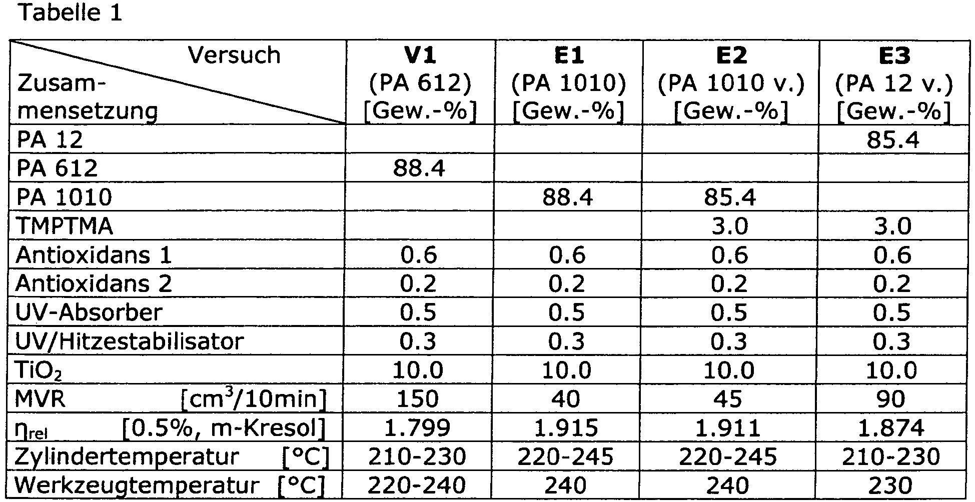

Tabelle 2 zeigt die Änderung der Schlagzugzähigkeit und Farbe während der Ofenlagerung bei 80 °C.

**Tabelle 2**

| Ofenlagerung 80°C | **V1** | **E1** | **E2** | **E3** |
|---|---|---|---|---|
| Zeit [h] | Schlaqzuqzähiqkeit [kJ/m²] | | | |
| 0 | 33 | 68 | 57 | 41 |
| 288 | 32 | 52 | 48 | 39 |
| 750 | 27 | 49 | 38 | 39 |
| 1488 | 33 | 45 | 41 | 37 |
| 2496 | 28 | 37 | 25 | 40 |

| Zeit [h] | Farbdifferenz | | | |
|---|---|---|---|---|
| 0 | 0 | 0 | 0 | 0 |
| 288 | 1.0 | 0.7 | 1.9 | 1.8 |
| 750 | 3.7 | 1.5 | 2.5 | 3.1 |
| 1488 | 5.2 | 1.9 | 3.4 | 4.1 |
| 2496 | 6.6 | 2.4 | 3.9 | 4.9 |

Tabelle 3 zeigt die Änderung der Schlagzugzähigkeit und Farbe während der Bewitterung im Weatherometer.

**Tabelle 3**

| Bewitterung | **V1** | **E1** | **E2** | **E3** |
|---|---|---|---|---|
| Zeit [h] | Schlagzugzähigkeit [kJ/m²] | | | |
| 250 | 41 | 64 | 58 | 40 |
| 750 | 38 | 56 | 39 | 32 |
| 1500 | 37 | 64 | 44 | 35 |
| 2250 | 28 | 56 | 34 | 31 |
| 3000 | 24 | 45 | 29 | 31 |

| Zeit [h] | Farbdifferenz | | | |
|---|---|---|---|---|
| 0 | 0 | 0 | 0 | 0 |
| 250 | 1.5 | 0.4 | 0.5 | 0.4 |
| 750 | 2.0 | 0.8 | 0.8 | 0.7 |
| 1500 | 2.2 | 1.5 | 0.6 | 0.7 |
| 2250 | 2.3 | 1.6 | 0.3 | 0.3 |
| 3000 | 3.8 | 2.1 | 2.0 | 2.5 |

Prüfung der Verbundhaftung:
Hergestellte Folien im A4-Format von den Versuchsvarianten wurden mit Ethanol gereinigt, im Schichtenaufbau Polyamidfolie 0.3 mm / EVA-Schmelzkleberfolie für Solarmodule 0.5 mm / Polyamidfolie 0.3 mm in einer heizbaren Presse zwischen zwei Metallplatten verpresst, beginnend von Raumtemperatur bis 140°C in 10 min, 5 min Haltezeit und innerhalb von 10 min auf Raumtemperatur abgekühlt, wobei die oberen 35 mm zwischen den Polyamidfolien durch Trennpapier isoliert wurden.

Nach 24 h wurde der Folienverbund in Streifen zu 20 mm Breite und 155 mm Länge geschnitten. Die geschnittenen Folien wurden bei 70°C und 62,5% Luftfeuchte 1 Woche schnellkonditioniert. Nach Abkühlen auf Raumtemperatur wurde nach weiteren 24h die Zugfestigkeit des Folienverbundes bezüglich Schichtentrennung getestet.

Die am oberen Rand unverklebt vorliegenden Polyamidfolien dienten der Einspannung in eine Zugprüfmaschine.

Geprüft wurde mit einer Geschwindigkeit von 50 mm/min. Gemessen wurde die Höchstzugkraft Fₘₐₓ zur Trennung des Verbunds als Durchschnittswert, welcher für die erfindungsgemässe Anwendung über 40 N/cm liegen sollte.

Tabelle 4 zeigt eine Übersicht über die Verbundhaftung Polyamidfolie/ EVA-Folie für Solarmodule/Polyamidfolie.

**Tabelle 4**

| Polyamid-Folienmaterial | **V1** | **E1** | **E2** | **E3** |
|---|---|---|---|---|
| | (PA 612) | (PA 1010) | (PA 1010 v.) | (PA 12 v.) |
| Fₘₐₓ [N/cm] Mittelwert | 40 | 74 | 53 | 48 |

Die Versuche haben gezeigt, dass die erfindungsgemässen Varianten die Anforderungen erfüllen und deutlich bessere Eigenschaften und Beständigkeiten aufweisen als die Vergleichsvariante V1 (PA 612), welche dem Stand der Technik gemäss WO 2008/138021 A2 entspricht. Insbesondere die besonders bevorzugten Varianten E1 und E2 mit PA 1010 bzw. PA 1010 vernetzt haben unerwartet gut abgeschnitten.

## Patentansprüche

1. Eine aus einer auf mindestens einem Polyamid basierenden Formmasse hergestellte Photovoltaikmodul-Monorückfolie, wobei die Polyamid-Formmasse mindestens ein Weisspigment als Zusatzstoff enthält, **dadurch gekennzeichnet, dass** das mindestens eine Polyamid aufgebaut ist aus linearen und/oder verzweigten aliphatischen und/oder cycloaliphatischen Monomeren, die im Durchschnitt mindestens 8 und maximal 17 C-Atome aufweisen und die ausgewählt sind aus der Gruppe bestehend aus Diaminen, Dicarbonsäuren, Lactamen und Aminocarbonsäuren sowie Mischungen derselben,
wobei Polyamid 610 und Polyamid 612 ausgeschlossen sind, und wobei die auf Lactamen und Aminocarbonsäuren basierenden Polyamide vernetzt sind, wobei das Polyamid ausgewählt ist aus der Gruppe Polyamid 4**X**, Polyamid 4**X** vernetzt, Polyamid 9 vernetzt, Polyamid 99, Polyamid 99 vernetzt, Polyamid 910, Polyamid 910 vernetzt, Polyamid 1010, Polyamid 1010 vernetzt, Polyamid 11 vernetzt, Polyamid 12 vernetzt, Polyamid 1010/10CHDA, Polyamid 1010/10CHDA vernetzt, Polyamid 610/10CHDA, Polyamid 610/10CHDA vernetzt, Polyamid 612/10CHDA, Polyamid 612/10CHDA vernetzt, Polyamid 910/10CHDA, Polyamid 910/10CHDA vernetzt, Polyamid 912/10CHDA, Polyamid 912/10CHDA vernetzt, Polyamid 1012/10CHDA, Polyamid 1012/10CHDA vernetzt, Polyamid 610/12CHDA, Polyamid 610/12CHDA vernetzt, Polyamid 612/12CHDA, Polyamid 612/12CHDA vernetzt, Polyamid 910/12CHDA, Polyamid 910/12CHDA vernetzt, Polyamid 912/12CHDA, Polyamid 912/12CHDA vernetzt, Polyamid 1012/12CHDA, Polyamid 1012/12CHDA vernetzt, Polyamid 1212/12CHDA, Polyamid 1212/12CHDA vernetzt, Polyamid 1212/10CHDA, Polyamid 1212/10CHDA vernetzt, Polyamid 1012, Polyamid 1012 vernetzt, Polyamid 1014, Polyamid 1014 vernetzt, Polyamid 1212 vernetzt, Polyamid 1210, Polyamid 1210 vernetzt, Polyamid MACM**Y** vernetzt, Polyamid PACM**Y** vernetzt, Polyamid MACM**Y**/PACM**Y** vernetzt, und Mischungen davon,
wobei:
**X** eine lineare aliphatische Dicarbonsäure mit 12 bis 18 C-Atomen bezeichnet, und
**Y** eine lineare aliphatische Dicarbonsäure mit 9 bis 18 C-Atomen bezeichnet.

2. Photovoltaikmodul-Monorückfolie gemäss Anspruch 1, **dadurch gekennzeichnet, dass** das Polyamid ausgewählt ist aus der Gruppe Polyamid 1010 und Polyamid 1010 vernetzt.

3. Photovoltaikmodul-Monorückfolie gemäss einem der Ansprüche 1 oder 2, **dadurch gekennzeichnet, dass** die Polyamid-Formmasse mindestens einen weiteren Zusatzstoff enthält, der ausgewählt ist aus einer Gruppe, die aus UV-Stabilisatoren, UV-Absorbern, Antioxidantien, Hitzestabilisatoren, Hydrolysestabilisatoren, Vernetzungsaktivatoren, Flammschutzmitteln, Schichtsilikaten, Füllstoffen, Farbmitteln, Verstärkungsmitteln, Haftvermittlern, Schlagzähigkeitsmodifikatoren und Fluorpolymeren besteht.

4. Photovoltaikmodul-Monorückfolie gemäss Anspruch 1, **dadurch gekennzeichnet, dass** das Weisspigment Titandioxid ist.

5. Photovoltaikmodul-Monorückfolie gemäss Anspruch 1, **dadurch gekennzeichnet, dass** sie eine Reflektivität von mindestens 92 % aufweist.

6. Verfahren zur Herstellung einer Photovoltaikmodul-Monorückfolie aus einer auf mindestens einem Polyamid basierenden Formmasse, die mindestens ein Weisspigment als Zusatzstoff enthält, gemäss einem der Ansprüche 1 bis 5, **dadurch gekennzeichnet, dass** diese Polyamid-Formmasse extrudiert wird, wobei das mindestens eine Polyamid aufgebaut ist aus linearen und/oder verzweigten aliphatischen und/oder cycloaliphatischen Monomeren, die im Durchschnitt mindestens 8 und maximal 17 C-Atome aufweisen und die ausgewählt werden aus der Gruppe bestehend aus Diaminen, Dicarbonsäuren, Lactamen und Aminocarbonsäuren sowie Mischungen derselben,
wobei Polyamid 610 und Polyamid 612 ausgeschlossen sind, und wobei die auf Lactamen und Aminocarbonsäuren basierenden Polyamide vernetzt werden,
wobei das Polyamid ausgewählt wird aus der Gruppe Polyamid 4**X**, Polyamid 4**X** vernetzt, Polyamid 9 vernetzt, Polyamid 99, Polyamid 99 vernetzt, Polyamid 910, Polyamid 910 vernetzt, Polyamid 1010, Polyamid 1010 vernetzt, Polyamid 11 vernetzt, Polyamid 12 vernetzt, Polyamid 1010/10CHDA, Polyamid 1010/10CHDA vernetzt, Polyamid 610/10CHDA, Polyamid 610/10CHDA vernetzt, Polyamid 612/10CHDA, Polyamid 612/10CHDA vernetzt, Polyamid 910/10CHDA, Polyamid 910/10CHDA vernetzt, Polyamid 912/10CHDA, Polyamid 912/10CHDA vernetzt, Polyamid 1012/10CHDA, Polyamid 1012/10CHDA vernetzt, Polyamid 610/12CHDA, Polyamid 610/12CHDA vernetzt, Polyamid 612/12CHDA, Polyamid 612/12CHDA vernetzt, Polyamid 910/12CHDA, Polyamid 910/12CHDA vernetzt, Polyamid 912/12CHDA, Polyamid 912/12CHDA vernetzt, Polyamid 1012/12CHDA, Polyamid 1012/12CHDA vernetzt, Polyamid 1212/12CHDA, Polyamid 1212/12CHDA vernetzt, Polyamid 1212/10CHDA, Polyamid 1212/10CHDA vernetzt, Polyamid 1012, Polyamid 1012 vernetzt, Polyamid 1014, Polyamid 1014 vernetzt, Polyamid 1212 vernetzt, Polyamid 1210, Polyamid 1210 vernetzt, Polyamid MACM**Y** vernetzt, Polyamid PACM**Y** vernetzt, Polyamid MACM**Y**/PACM**Y** vernetzt, und Mischungen davon,
wobei:
**X** eine lineare aliphatische Dicarbonsäure mit 12 bis 18 C-Atomen bezeichnet, und
**Y** eine lineare aliphatische Dicarbonsäure mit 9 bis 18 C-Atomen bezeichnet.

7. Verfahren zur Herstellung einer Photovoltaikmodul-Monorückfolie gemäss Anspruch 6, **dadurch gekennzeichnet, dass** zur Erzielung einer Vernetzung des Polyamids der Polyamid-Formmasse vor der Formgebung ein Vernetzungsaktivator zudosiert wird.

8. Verfahren zur Herstellung einer Photovoltaikmodul-Monorückfolie gemäss Anspruch 7, **dadurch gekennzeichnet, dass** eine Folie extrudiert und die Vernetzung an der extrudierten Folie durch energiereiche Bestrahlung ausgelöst wird.

9. Verfahren zur Herstellung einer Photovoltaikmodul-Monorückfolie gemäss Anspruch 8, **dadurch gekennzeichnet, dass** die energiereiche Bestrahlung durch Elektronenbestrahlung erfolgt.

10. Verfahren zur Herstellung einer Photovoltaikmodul-Monorückfolie gemäss einem der Ansprüche 7 bis 9, **dadurch gekennzeichnet, dass** der Vernetzungsaktivator ausgewählt ist aus der Gruppe Trimethylolpropantrimethacrylat und Triallylisocyanurat.

11. Verwendung einer Photovoltaikmodul-Monorückfolie gemäss einem der Ansprüche 1 bis 5 oder eines Verfahrens zu deren Herstellung gemäss einem der Ansprüche 6 bis 10 bei der Produktion photovoltaischer Module.

## Claims

1. A photovoltaic module mono-backsheet produced from a molding compound based on at least one polyamide, the polyamide molding compound containing at least one white pigment as an additive, **characterized in that** the at least one polyamide is synthesized from linear and/or branched aliphatic and/or cycloaliphatic monomers, which have an average of at least 8 and at most 17 C atoms and which are selected from the group consisting of diamines, dicarboxylic acids, lactams, and amino carboxylic acids as well as mixtures thereof,
polyamide 610 and polyamide 612 being excluded, and the polyamides based on lactams and amino carboxylic acids being cross-linked,
wherein the polyamide is selected from the group polyamide 4**X**, polyamide 4**X** cross-linked, polyamide 9 cross-linked, polyamide 99, polyamide 99 cross-linked, polyamide 910, polyamide 910 cross-linked, polyamide 1010, polyamide 1010 cross-linked, polyamide 11 cross-linked, polyamide 12 cross-linked, polyamide 1010/10CHDA, polyamide 1010/10CHDA cross-linked, polyamide 610/10CHDA, polyamide 610/10CHDA cross-linked, polyamide 612/10CHDA, polyamide 612/10CHDA cross-linked, polyamide 910/10CHDA, polyamide 910/10CHDA cross-linked, polyamide 912/10CHDA, polyamide 912/10CHDA cross-linked, polyamide 1012/10CHDA, polyamide 1012/10CHDA cross-linked, polyamide 610/12CHDA, polyamide 610/12CHDA cross-linked, polyamide 612/12CHDA, polyamide 612/12CHDA cross-linked, polyamide 910/12CHDA, polyamide 910/12CHDA cross-linked, polyamide 912/12CHDA, polyamide 912/12CHDA cross-linked, polyamide 1012/12CHDA, polyamide 1012/12CHDA cross-linked, polyamide 1212/12CHDA, polyamide 1212/12CHDA cross-linked, polyamide 1212/10CHDA, polyamide 1212/10CHDA cross-linked, polyamide 1012, polyamide 1012 cross-linked, polyamide 1014, polyamide 1014 cross-linked, polyamide 1212 cross-linked, polyamide 1210, polyamide 1210 cross-linked, polyamide MACM**Y** cross-linked, polyamide PACM**Y** cross-linked, polyamide MACM**Y**/PACM**Y** cross-linked, and mixtures thereof,
where:
**X** designates a linear aliphatic dicarboxylic acid having 12 to 18 C atoms, and
**Y** designates a linear aliphatic dicarboxylic acid having 9 to 18 C atoms.

2. The photovoltaic module mono-backsheet according to Claim 1, **characterized in that** the polyamide is selected from the group polyamide 1010 and polyamide 1010 cross-linked.

3. The photovoltaic module mono-backsheet according to one of Claims 1 or 2, **characterized in that** the polyamide molding compound contains at least one further additive which is selected from a group which consists of UV stabilizers, UV absorbers, antioxidants, heat stabilizers, hydrolysis stabilizers, cross-linking activators, flame retardants, layered silicates, fillers, colorants, reinforcing agents, adhesion promoters, impact resistance modifiers, and fluoropolymers.

4. The photovoltaic module mono-backsheet according to Claim 1, **characterized in that** the white pigment is titanium dioxide.

5. The photovoltaic module mono-backsheet according to Claim 1, **characterized in that** it has a reflectivity of at least 92%.

6. A method for producing a photovoltaic module mono-backsheet from a molding compound based on at least one polyamide, the molding compound containing at least one white pigment as an additive, according to one of Claims 1 to 5, **characterized in that** this polyamide molding compound is extruded, the at least one polyamide being synthesized from linear and/or branched aliphatic and/or cycloaliphatic monomers, which have an average of at least 8 and at most 17 C atoms and which are selected from the group consisting of diamines, dicarboxylic acids, lactams, and amino carboxylic acids, as well as mixtures thereof,
polyamide 610 and polyamide 612 being excluded, and the polyamides based on lactams and amino carboxylic acids being cross-linked,
wherein the polyamide is selected from the group polyamide 4**X**, polyamide 4**X** cross-linked, polyamide 9 cross-linked, polyamide 99, polyamide 99 cross-linked, polyamide 910, polyamide 910 cross-linked, polyamide 1010, polyamide 1010 cross-linked, polyamide 11 cross-linked, polyamide 12 cross-linked, polyamide 1010/10CHDA, polyamide 1010/10CHDA cross-linked, polyamide 610/10CHDA, polyamide 610/10CHDA cross-linked, polyamide 612/10CHDA, polyamide 612/10CHDA cross-linked, polyamide 910/10CHDA, polyamide 910/10CHDA cross-linked, polyamide 912/10CHDA, polyamide 912/10CHDA cross-linked, polyamide 1012/10CHDA, polyamide 1012/10CHDA cross-linked, polyamide 610/12CHDA, polyamide 610/12CHDA cross-linked, polyamide 612/12CHDA, polyamide 612/12CHDA cross-linked, polyamide 910/12CHDA, polyamide 910/12CHDA cross-linked, polyamide 912/12CHDA, polyamide 912/12CHDA cross-linked, polyamide 1012/12CHDA, polyamide 1012/12CHDA cross-linked, polyamide 1212/12CHDA, polyamide 1212/12CHDA cross-linked, polyamide 1212/10CHDA, polyamide 1212/10CHDA cross-linked, polyamide 1012, polyamide 1012 cross-linked, polyamide 1014, polyamide 1014 cross-linked, polyamide 1212 cross-linked, polyamide 1210, polyamide 1210 cross-linked, polyamide MACM**Y** cross-linked, polyamide PACM**Y** cross-linked, polyamide MACM**Y**/PACM**Y** cross-linked, and mixtures thereof,
where:
**X** designates a linear aliphatic dicarboxylic acid having 12 to 18 C atoms, and
**Y** designates a linear aliphatic dicarboxylic acid having 9 to 18 C atoms.

7. The method for producing a photovoltaic module mono-backsheet according to Claim 6, **characterized in that**, to achieve cross-linking of the polyamide of the polyamide molding compound before the shaping, a cross-linking activator is admixed.

8. The method for producing a photovoltaic module mono-backsheet according to Claim 7, **characterized in that** a sheet is extruded and cross-linking is triggered on the extruded sheet by high-energy irradiation.

9. A method for producing a photovoltaic module mono-backsheet according to Claim 8, **characterized in that** the high-energy irradiation is performed by electron irradiation.

10. The method for producing a photovoltaic module mono-backsheet according to one of Claims 7 to 9, **characterized in that** the cross-linking activator is selected from the group trimethylolpropane trimethacrylate and triallyl isocyanurate.

11. A use of a photovoltaic module mono-backsheet according to one of Claims 1 to 5 or of a method for the production thereof according to one of Claims 6 to 10 during the production of photovoltaic modules.

## Revendications

1. Monofeuille arrière pour module photovoltaïque fabriqué à partir d'une matière moulable à base d'au moins un polyamide, la matière moulable à base de polyamide contenant au moins un pigment blanc comme additif, **caractérisée en ce que** le polyamide, au moins au nombre de un, est formé de monomères aliphatiques linéaires et/ou ramifiés et/ou cycloaliphatiques, qui présentent en moyenne au moins 8 à un maximum de 17 atomes de C et qui sont sélectionnés dans le groupe composé des diamines, des acides dicarboxyliques, des lactames, des acides aminocarboxyliques, ainsi que de mélanges de ceux-ci, le polyamide 610 et le polyamide 612 étant exclus, et les polyamides à base de lactames et d'acides aminocarboxyliques étant réticulés,
**caractérisée en ce que** le polyamide est sélectionné dans le groupe composé de polyamide 4**X**, polyamide 4**X** réticulé, polyamide 9 réticulé, polyamide 99, polyamide 99 réticulé, polyamide 910, polyamide 910 réticulé, polyamide 1010, polyamide 1010 réticulé, polyamide 11 réticulé, polyamide 12 réticulé, polyamide 1010/10CHDA, polyamide 1010/10CHDA réticulé, polyamide 610/10CHDA, polyamide 610/10CHDA réticulé, polyamide 612/10CHDA, polyamide 612/10CHDA réticulé, polyamide 910/10CHDA, polyamide 910/10CHDA réticulé, polyamide 912/10CHDA, polyamide 912/10CHDA réticulé, polyamide 1012/10CHDA, polyamide 1012/10CHDA réticulé, polyamide 610/12CHDA, polyamide 610/12CHDA réticulé, polyamide 612/12CHDA, polyamide 612/12CHDA réticulé, polyamide 910/12CHDA, polyamide 910/12CHDA réticulé, polyamide 912/12CHDA, polyamide 912/12CHDA réticulé, polyamide 1012/12CHDA, polyamide 1012/12CHDA réticulé, polyamide 1212/12CHDA, polyamide 1212/12CHDA réticulé, polyamide 1212/10CHDA, polyamide 1212/10CHDA réticulé, polyamide 1012, polyamide 1012 réticulé, polyamide 1014, polyamide 1014 réticulé, polyamide 1212 réticulé, polyamide 1210, polyamide 1210 réticulé, polyamide MACM**Y** réticulé, polyamide PACM**Y** réticulé, polyamide MACM**Y**/PACM**Y** réticulé, et des mélanges de ceux-ci,
où :
**X** est un acide dicarboxylique aliphatique linéaire comportant 12 à 18 atomes de C, et
**Y** est un acide dicarboxylique aliphatique linéaire comportant 9 à 18 atomes de C.

2. Monofeuille arrière pour module photovoltaïque selon la revendication 1, **caractérisée en ce que** le polyamide est sélectionné dans le groupe composé du polyamide 1010 et du polyamide 1010 réticulé.

3. Monofeuille arrière pour module photovoltaïque selon l'une des revendications 1 ou 2, **caractérisée en ce que** la matière moulable de polyamide contient au moins un autre additif qui est sélectionné dans un groupe qui se compose de stabilisateurs d'UV, d'absorbeurs d'UV, d'antioxydants, de stabilisateurs de chaleur, de stabilisateurs d'hydrolyse, d'activateurs de réticulation, d'agents ignifuges, de silicates lamellaires, de matières de charge, de colorants, d'agents de renforcement, d'agents adhésifs, de modificateurs de la résistance au choc et de fluoropolymères.

4. Monofeuille arrière pour module photovoltaïque selon la revendication 1, **caractérisée en ce que** le pigment blanc est du dioxyde de titane.

5. Monofeuille arrière pour module photovoltaïque selon la revendication 1, **caractérisée en ce qu'**elle présente une réflectivité au moins égale à 92 %.

6. Procédé de fabrication d'une monofeuille arrière pour module photovoltaïque à partir d'une matière moulable à base d'au moins un polyamide qui contient au moins un pigment blanc comme additif, selon l'une des revendications 1 à 5, **caractérisé en ce que** cette matière moulable de polyamide est extrudée, le polyamide, au moins au nombre de un, étant formé à partir de monomères aliphatiques linéaires et/ou ramifiés et/ou cycloaliphatiques, qui présentent en moyenne au moins 8 et au maximum 17 atomes de C et sont sélectionnés dans le groupe composé des diamines, des acides dicarboxyliques, des lactames et des acides aminocarboxyliques, ainsi que de leurs mélanges,
le polyamide 610 et le polyamide 612 étant exclus, et les polyamides à base de lactames et d'acides aminocarboxyliques étant réticulés,
**caractérisée en ce que** le polyamide est sélectionné dans le groupe composé de polyamide 4**X**, polyamide 4**X** réticulé, polyamide 9 réticulé, polyamide 99, polyamide 99 réticulé, polyamide 910, polyamide 910 réticulé, polyamide 1010, polyamide 1010 réticulé, polyamide 11 réticulé, polyamide 12 réticulé, polyamide 1010/10CHDA, polyamide 1010/10CHDA réticulé, polyamide 610/10CHDA, polyamide 610/10CHDA réticulé, polyamide 612/10CHDA, polyamide 612/10CHDA réticulé, polyamide 910/10CHDA, polyamide 910/10CHDA réticulé, polyamide 912/10CHDA, polyamide 912/10CHDA réticulé, polyamide 1012/10CHDA, polyamide 1012/10CHDA réticulé, polyamide 610/12CHDA, polyamide 610/12CHDA réticulé, polyamide 612/12CHDA, polyamide 612/12CHDA réticulé, polyamide 910/12CHDA, polyamide 910/12CHDA réticulé, polyamide 912/12CHDA, polyamide 912/12CHDA réticulé, polyamide 1012/12CHDA, polyamide 1012/12CHDA réticulé, polyamide 1212/12CHDA, polyamide 1212/12CHDA réticulé, polyamide 1212/10CHDA, polyamide 1212/10CHDA réticulé, polyamide 1012, polyamide 1012 réticulé, polyamide 1014, polyamide 1014 réticulé, polyamide 1212 réticulé, polyamide 1210, polyamide 1210 réticulé, polyamide MACM**Y** réticulé, polyamide PACM**Y** réticulé, polyamide MACM**Y**/PACM**Y** réticulé, et des mélanges de ceux-ci,
où :
**X** est un acide dicarboxylique aliphatique linéaire comportant 12 à 18 atomes de C, et
**Y** est un acide dicarboxylique aliphatique linéaire comportant 9 à 18 atomes de C.

7. Procédé de fabrication d'une monofeuille arrière pour module photovoltaïque selon la revendication 6, **caractérisé en ce que** pour obtenir une réticulation du polyamide de la matière moulable de polyamide, on ajoute avant le façonnage un activateur de réticulation.

8. Procédé de fabrication d'une monofeuille arrière pour module photovoltaïque selon la revendication 7, **caractérisé en ce qu'**une feuille est extrudée et **en ce que** la réticulation au niveau de la feuille extrudée est déclenchée par un rayonnement à haute énergie.

9. Procédé de fabrication d'une monofeuille arrière pour module photovoltaïque selon la revendication 8, **caractérisé en ce que** le rayonnement à haute énergie se fait par irradiation d'électrons.

10. Procédé de fabrication d'une monofeuille arrière pour module photovoltaïque selon l'une des revendications 7 à 9, **caractérisé en ce que** l'activateur de réticulation est sélectionné dans le groupe composé du triméthacrylate de triméthylolpropane et de l'isocyanurate de triallyle.

11. Utilisation d'une monofeuille arrière pour module photovoltaïque selon l'une des revendications 1 à 5 ou d'un procédé de fabrication de celle-ci selon l'une des revendications 6 à 10 pour la production de modules photovoltaïques.
